# EUROPEAN PATENT SPECIFICATION

(11) **EP 3 306 621 B1**
(45) Date of publication and mention of the grant of the patent: **29.01.2020**
(21) Application number: 16836943.7
(22) Date of filing: 27.07.2016
(51) Int. Cl.: H01B 7/06, H01R 11/01, H01B 5/16, H01B 7/08, H01B 13/008

(54) **ELASTIC CONDUCTOR**
ELASTISCHER LEITER
CONDUCTEUR ÉLASTIQUE

(30) Priority: 20.08.2015 JP 2015162721
(43) Date of publication of application: 11.04.2018
(73) Proprietor: Murata Manufacturing Co., Ltd., Nagaokakyo-shi, Kyoto 617-8555 (JP)
(72) Inventor: SEKIMOTO, Yasuyuki, Nagaokakyo-shi Kyoto 617-8555 (JP)
(74) Representative: Zimmermann, Tankred Klaus
(86) International application number: PCT/JP2016/071972
(87) International publication number: WO 2017/029952

(56) References cited:
- WO-A1-2015/034358
- JP-A- 2005 259 609
- JP-A- 2008 058 286
- JP-A- 2011 070 821
- US-A1- 2013 214 214
- US-A1- 2015 129 276
- US-B2- 7 491 892

## Description

### TECHNICAL FIELD

The present invention relates to an elastic conductor configured to be changeable between the first state before tensile force acts in the first direction and the second state in which the tensile force acts in the first direction to cause the elastic conductor to be expanded in the first direction.

### BACKGROUND ART

JP 2005-322492 A discloses an elastic conductor configured to be stretchable. In the elastic conductor disclosed in JP 2005-322492 A, particulate or fibrous magnetic conductors are kneaded into a rubber-like elastic body. Then, in the state in which the magnetic conductors are oriented in a prescribed first direction by a magnetic field, some of the magnetic conductors are branched in the second direction that crosses the first direction.

By the configuration as described above, the magnetic conductors branched in the second direction can form a connection between the magnetic conductors oriented in the first direction. Thereby, the electrical resistance can be lowered while excellent conduction can be achieved. US 2015/129276 A1 describes a deformable elastomeric conductor for transmitting electrical signals which comprises an elastomeric polymer matrix and a conductive filler material uniformly dispersed in the elastomeric polymer matrix sufficient to render the material electrically conductive. The conductive filler material may include substantially non-entangled particles having an aspect ratio sufficiently large to enable the particles to substantially remain in contact and/or in close proximity with adjacent particles so as to maintain conductive pathways in the material when the material is subjected to deformation.US 2013/214214 A1 describes a conductive elastic composite that retains conductivity despite stretching, wherein the conductive elastic composite comprises an elastomeric matrix, carbon nanotubes and carbon fibers.

US 7,491,892 B2 describes stretchable interconnects formed of a conductive film covering an elastomeric or plastic substrate. When this structure is stretched in one or two dimensions, it retains electrical conduction in both dimensions.

WO 2015/034358 A1 describes a bendable electrically interconnecting foil for making flexible electronic circuits. The foil comprises a flexible substrate and stretchable conductive tracks for connecting the electronic components. Between the substrate and the tracks a resilient layer is situated.

### SUMMARY OF INVENTION

### TECHNICAL PROBLEM

According to the configuration disclosed in JP 2005-322492 A, however, when the elastic conductor is expanded to a considerable degree in the first direction in which the metal particles are oriented, the connection between the particulate or fibrous magnetic conductors oriented in the first direction is disconnected. This leads to a fear that the electrical resistance of the elastic conductor may increase.

The present invention has been made in light of the above-described problems. An object of the present invention is to provide an elastic conductor capable of suppressing an increase in electrical resistance caused by an increase in path length when the elastic conductor is expanded in a prescribed direction.

This object is achieved by an elastic conductor according to claim 1.

### SOLUTION TO PROBLEM

An elastic conductor according to the present invention is configured to be changeable between a first state before tensile force acts in a first direction and a second state in which the tensile force acts in the first direction to cause the elastic conductor to be expanded in the first direction. The elastic conductor includes: a stretchable base member having conductivity; and a plurality of conductive members each having a longitudinal shape extending in the first direction and arranged on a surface of the stretchable base member or inside the stretchable base member, each of the plurality of conductive members being lower in specific resistance and higher in modulus of elasticity than the stretchable base member. In the first state, the plurality of conductive members are arranged to be spaced apart from each other in a second direction perpendicular to the first direction, and to be continuous in at least a partial section extending in the first direction as seen in the second direction from one end of the partial section to the other end of the partial section in the first direction, in which a distance between conductive members adjacent to each other in the second direction in the second state is shorter than a distance between conductive members adjacent to each other in the second direction in the first state.

In the elastic conductor according to the present invention, it is preferable that each of the plurality of conductive members is formed of a metal material in a bulk state or metal foil. In this case, the metal material in a bulk state means a massive metal material made of hardened metal, but does not include a metal material formed by drying a binder containing a large amount of metal particles such as a paste material.

The elastic conductor according to the present invention may further include a restraint member that is higher in modulus of elasticity than the stretchable base member, the restraint member being configured to suppress expansion and contraction of the stretchable base member in the second direction. In this case, in the at least a partial section, two or more conductive members of the plurality of conductive members are arranged side by side in the second direction, to form: a dense region where the conductive members along a width of the stretchable base member in the second direction are dense in number; and a sparse region where the conductive members along the width of the stretchable base member in the second direction are more sparse in number than the dense region. Furthermore, it is preferable that the restraint member is provided on a back surface of the stretchable base member or inside the stretchable base member so as to overlap with the sparse region as seen in a normal direction of the surface of the stretchable base member.

The elastic conductor according to the present invention may further include a restraint member that is higher in modulus of elasticity than the stretchable base member, the restraint member being configured to suppress expansion and contraction of the stretchable base member in the second direction. In this case, an electronic component mounted region having an electronic component mounted thereon may be provided on the surface of the stretchable base member, the surface being adjacent to the at least a partial section. Furthermore, it is preferable that the restraint member is provided on a back surface of the stretchable base member so as to overlap with the electronic component mounted region as seen in a normal direction of the surface of the stretchable base member.

The elastic conductor according to the present invention may further include an elastic base member having a first main surface and a second main surface that face in opposite directions, the elastic base member being configured to support the stretchable base member and the plurality of conductive members. In this case, it is preferable that the plurality of conductive members are provided on the first main surface, and also preferable that the stretchable base member is provided on the first main surface to cover the plurality of conductive members.

The elastic conductor according to the present invention may further include a restraint member that is higher in modulus of elasticity than the elastic base member, the restraint member being configured to restrain expansion and contraction of the elastic base member in the second direction. In this case, it is preferable that, in the at least a partial section, two or more conductive members of the plurality of conductive members are arranged side by side in the second direction, to form: a dense region where the conductive members along a width of the stretchable base member in the second direction are dense in number; and a sparse region where the conductive members along the width of the stretchable base member in the second direction are more sparse in number than the dense region. Furthermore, it is preferable that the restraint member is provided on the second main surface so as to overlap with the sparse region as seen in a normal direction of the second main surface.

The elastic conductor according to the present invention may further include a restraint member that is higher in modulus of elasticity than the elastic base member, the restraint member being configured to suppress expansion of the elastic base member in the second direction. In this case, it is preferable that an electronic component mounted region having an electronic component mounted thereon is provided on the surface of the stretchable base member, the surface being adjacent to the at least a partial section. Furthermore, it is preferable that the restraint member is provided on the second main surface so as to overlap with the electronic component mounted region as seen in a normal direction of the second main surface.

### ADVANTAGEOUS EFFECTS OF INVENTION

According to the present invention, it becomes possible to provide an elastic conductor capable of suppressing an increase in electrical resistance caused by an increase in path length when the elastic conductor is expanded in a prescribed direction.

### BRIEF DESCRIPTION OF DRAWINGS

Fig. 1 is a plan view of an elastic conductor according to the first embodiment.
Fig. 2 is a cross-sectional view taken along a line II-II shown in Fig. 1.
Fig. 3 is a diagram showing the state in which the elastic conductor according to the first embodiment is tensioned in the first direction.
Fig. 4 is a cross-sectional view showing the first step of a method of manufacturing the elastic conductor according to the first embodiment.
Fig. 5 is a cross-sectional view showing the second step of the method of manufacturing the elastic conductor according to the first embodiment.
Fig. 6 is a cross-sectional view showing the third step of the method of manufacturing the elastic conductor according to the first embodiment.
Fig. 7 is a cross-sectional view showing the fourth step of the method of manufacturing the elastic conductor according to the first embodiment.
Fig. 8 is a cross-sectional view showing the fifth step of the method of manufacturing the elastic conductor according to the first embodiment.
Fig. 9 is a plan view of an elastic conductor according to the second embodiment.
Fig. 10 is a plan view of an elastic conductor according to the third embodiment.
Fig. 11 is a plan view of an elastic conductor according to the fourth embodiment.
Fig. 12 is a plan view of an elastic conductor according to the fifth embodiment.
Fig. 13 is a cross-sectional view taken along a line XIII-XIII shown in Fig. 12.
Fig. 14 is a diagram showing the state in which the elastic conductor according to the fifth embodiment is tensioned in the first direction.
Fig. 15 is a plan view of an elastic conductor according to the sixth embodiment.
Fig. 16 is a cross-sectional view taken along a line XVI-XVI shown in Fig. 15.
Fig. 17 is a diagram showing the state in which the elastic conductor according to the sixth embodiment is tensioned in the first direction.
Fig. 18 is a cross-sectional view of an elastic conductor according to the seventh embodiment.
Fig. 19 is a diagram showing the first step of a method of manufacturing the elastic conductor according to the seventh embodiment.
Fig. 20 is a diagram showing the second step of the method of manufacturing the elastic conductor according to the seventh embodiment.
Fig. 21 is a diagram showing the third step of the method of manufacturing the elastic conductor according to the seventh embodiment.
Fig. 22 is a diagram showing the fourth step of the method of manufacturing the elastic conductor according to the seventh embodiment.
Fig. 23 is a diagram showing the fifth step of the method of manufacturing the elastic conductor according to the seventh embodiment.
Fig. 24 is a diagram showing the sixth step of the method of manufacturing the elastic conductor according to the seventh embodiment.
Fig. 25 is a diagram showing conditions and results of a verification experiment performed for verifying the effect of the present invention.
Fig. 26 is a diagram showing the first state of the first use example of the elastic conductor according to the present invention.
Fig. 27 is a diagram showing the second state of the first use example of the elastic conductor according to the present invention.
Fig. 28 is a diagram showing the first state of the second use example of the elastic conductor according to the present invention.
Fig. 29 is a diagram showing the second state of the second use example of the elastic conductor according to the present invention.

### DESCRIPTION OF EMBODIMENTS

Embodiments of the present invention will be hereinafter described in detail with reference to the accompanying drawings. In the embodiments hereinafter described, the same or corresponding components are designated by the same reference characters, and description thereof will not be repeated.

### (First Embodiment)

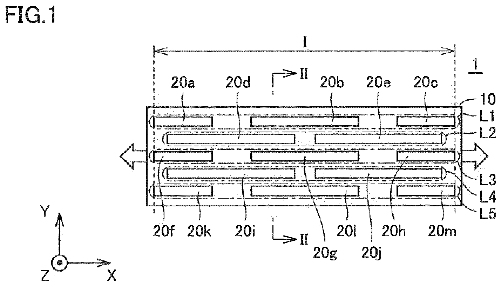

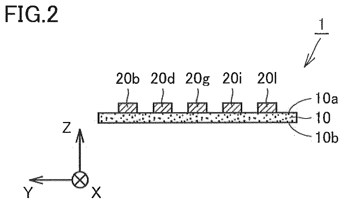

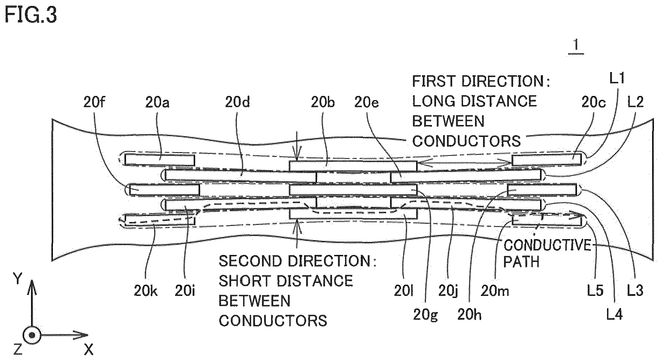

Fig. 1 is a plan view of an elastic conductor according to the first embodiment. Fig. 2 is a cross-sectional view taken along a line II-II in Fig. 1. Fig. 3 is a diagram showing the state in which the elastic conductor according to the first embodiment is tensioned in the first direction. Referring to Figs. 1 to 3, an elastic conductor 1 according to the present embodiment will be hereinafter described.

As shown in Figs. 1 to 3, elastic conductor 1 according to the present embodiment is configured to be changeable between: the first state before tensile force acts in the first direction; and the second state in which the tensile force acts in the first direction to cause elastic conductor 1 to be expanded in the first direction. Figs. 1 and 2 each show the first state of elastic conductor 1, and Fig. 3 shows the second state of elastic conductor 1.

As shown in Figs. 1 and 2, elastic conductor 1 includes a stretchable base member 10 having conductivity and a plurality of conductive members 20a to 20m. Stretchable base member 10 is configured to be stretchable.

Stretchable base member 10 has an approximately rectangular shape, for example. Specifically, stretchable base member 10 has an approximately rectangular shape in plan view, for example, in which an X-axis direction corresponding to the first direction is defined as a long side direction while a Y-axis direction corresponding to the second direction orthogonal to the first direction is defined as a short side direction. In addition, the Z-axis direction corresponds to the thickness direction of stretchable base member 10.

Stretchable base member 10 can be made using a material obtained by kneading a rubber material or resin with conductive powder (such as spherical powder, fibrous powder, or flake-shaped powder). Specifically, stretchable base member 10 can be made using a material obtained by adding a carbon filler to a thermoplastic elastomer such as styrene ethylene butylene styrene copolymer (SEBS), for example. Examples of a rubber material may be nitrile rubber (NBR), chloroprene rubber (CR), ethylene propylene rubber (EPDM), silicone rubber, isobutylene-isoprene rubber (IIR), styrene rubber (SBR), urethane rubber, Hypalon (CSM), fluoro-rubber (FKM), and the like. Furthermore, it is preferable to use a rubber material having one or more of characteristics including: 1) modulus of elasticity of about several MPa; 2) heat resistance equal to or higher than 100 °C at lowest, preferably, equal to or higher than 150 °C to 200 °C; 3) shape restorability; 4) bioaffinity; and 5) moisture permeability. As conductive powder, in addition to a carbon filler, metal such as Ag, Cu, Al, Zn, Ni, and Sn or an alloy made of two or more of these metals may be added.

The plurality of conductive members 20a to 20m each have a longitudinal shape extending in the first direction. The plurality of conductive members 20a to 20m are arranged on a surface 10a of the stretchable base member. The plurality of conductive members 20a to 20m are lower in specific resistance and higher in modulus of elasticity than stretchable base member 10.

Each of the plurality of conductive members 20a to 20m is made, for example, of metal foil. For example, copper foil can be used as metal foil. The plurality of conductive members 20a to 20m are formed by a subtractive method such as a printing method, a photolithography method and a direct imaging method.

The plurality of conductive members 20a to 20m are arranged to be spaced apart from each other in the second direction perpendicular to the first direction, and to be continuous in at least a partial section I extending in the first direction as seen in the second direction from one end of partial section I to the other end of partial section I in the first direction.

The plurality of conductive members 20a to 20m are arranged in a staggered manner. Some conductive members of the plurality of conductive members 20a to 20m are linearly arranged so as to be spaced apart from each other in the first direction, with the result that a first line L1 to a fifth line L5 are formed. First line L1 to fifth line L5 are sequentially arranged so as to be spaced apart from each other in the Y-axis direction. Third line L3 is located in the center portion of stretchable base member 10 in the second direction.

First line L1, third line L3 and fifth line L5 have almost the same configuration. First line L1 includes conductive members 20a, 20b and 20c. Conductive members 20a, 20b and 20c are linearly arranged to be spaced apart from each other in the first direction. Third line L3 includes conductive members 20f, 20g and 20h. Conductive members 20f, 20g and 20h are linearly arranged to be spaced apart from each other in the first direction. Fifth line L5 includes conductive members 20k, 201 and 20m. Conductive members 20k, 201 and 20m are linearly arranged to be spaced apart from each other in the first direction.

Conductive members 20a, 20f and 20k are located on the one end side of section I. Conductive members 20a, 20f and 20k have almost the same length. One ends of conductive members 20a, 20f and 20k in the first direction overlap with one another as seen in the second direction. The other ends of conductive members 20a, 20f and 20k in the first direction overlap with one another as seen in the second direction. Conductive members 20a, 20f and 20k are arranged to be spaced apart from each other in the second direction.

Conductive members 20c, 20h and 20m are located on the other end side of section I. Conductive members 20c, 20h and 20m have almost the same length. One ends of conductive members 20c, 20h and 20m in the first direction overlap with one another as seen in the second direction. The other ends of conductive members 20c, 20h and 20m in the first direction overlap with one another as seen in the second direction. Conductive members 20c, 20h and 20m are arranged to be spaced apart from each other in the second direction.

Conductive members 20b, 20g and 201 are located between conductive members 20a, 20f and 20k and conductive members 20c, 20h and 20m in the first direction. Conductive members 20b, 20g and 201 have almost the same length. One ends of conductive members 20b, 20g and 201 in the first direction overlap with one another as seen in the second direction. The other ends of conductive members 20b, 20g and 201 in the first direction overlap with one another as seen in the second direction. Conductive members 20b, 20g and 201 are arranged to be spaced apart from each other in the second direction.

Second line L2 and fourth line L4 have almost the same configuration. Second line L2 includes conductive members 20d and 20e. Second line L2 is located between first line L1 and third line L3 in the second direction. Fourth line L4 is located between third line L3 and fifth line L5 in the second direction.

Conductive members 20d and 20e are linearly arranged to be spaced apart from each other in the first direction. The one end side of conductive member 20d in the first direction is located between conductive members 20a and 20f in the second direction. One end of conductive member 20d in the first direction is located more inward than one ends of conductive members 20a and 20f in the first direction. In other words, one end of conductive member 20d in the first direction is located closer to the other ends of conductive members 20a and 20f in the first direction than one ends of conductive members 20a and 20f in the first direction are.

The other end side of conductive member 20d in the first direction is located between conductive members 20b and 20g in the second direction. The other end of conductive member 20d in the first direction is located closer to one ends of conductive members 20b and 20g in the first direction than the center portions of conductive members 20b and 20g are.

The one end side of conductive member 20e in the first direction is located between conductive members 20b and 20g in the second direction. One end of conductive member 20e in the first direction is located closer to the other ends of conductive members 20b and 20g in the first direction than the center portions of conductive members 20b and 20g are.

The other end side of conductive member 20e in the first direction is located between conductive members 20c and 20h in the second direction. The other end of conductive member 20e in the first direction is located more inward than the other ends of conductive members 20c and 20h in the first direction. In other words, the other end of conductive member 20e in the first direction is located closer to one ends of conductive members 20c and 20h in the first direction than the other ends of conductive members 20c and 20h in the first direction are.

Conductive members 20i and 20j are linearly arranged to be spaced apart from each other in the first direction. The one end side of conductive member 20i in the first direction is located between conductive members 20f and 20k in the second direction. One end of conductive member 20i in the first direction is located more inward than one ends of conductive members 20f and 20k in the first direction. In other words, one end of conductive member 20i in the first direction is located closer to the other ends of conductive members 20f and 20k in the first direction than one ends of conductive members 20f and 20k in the first direction are.

The other end side of conductive member 20i in the first direction is located between conductive members 20g and 201 in the second direction. The other end of conductive member 20i in the first direction is located closer to one ends of conductive members 20g and 201 in the first direction than the center portions of conductive members 20g and 201 are.

The one end side of conductive member 20j in the first direction is located between conductive members 20g and 201 in the second direction. One end of conductive member 20j in the first direction is located closer to the other ends of conductive members 20g and 201 in the first direction than the center portions of conductive members 20g and 201 are.

The other end side of conductive member 20j in the first direction is located between conductive members 20h and 20m in the second direction. The other end of conductive member 20j in the first direction is located more inward than the other ends of conductive members 20h and 20m in the first direction. In other words, the other end of conductive member 20j in the first direction is located closer to one ends of conductive members 20h and 20m in the first direction than the other ends of conductive members 20h and 20m in the first direction are.

As shown in Fig. 3, in the second state in which tensile force acts in the first direction to cause elastic conductor 1 to be expanded in the first direction, stretchable base member 10 having a low modulus of elasticity extends in the first direction while suppressing deformation of the plurality of conductive members 20a to 20m each having a high modulus of elasticity. Thereby, as compared with the first state in which tensile force does not act in the first direction, the distance between the conductive members in the first direction is relatively long while the distance between the conductive members in the second direction is relatively short.

For example, in first line L1, the distance between conductive members 20a and 20b in the first direction is increased, and the distance between conductive members 20b and 20c in the first direction is increased. Similarly, in third line L3 and fifth line L5, the distance between conductive members 20f and 20g in the first direction is increased, the distance between conductive members 20g and 20h in the first direction is increased, the distance between conductive members 20k and 201 in the first direction is increased, and the distance between conductive members 201 and 20m in the first direction is increased.

On the other hand, first line L1 and second line L2 are brought closer to third line L3 located in the center portion of stretchable base member 10 in the second direction. Similarly, fourth line L4 and fifth line L5 are brought closer to third line L3 located in the center portion of stretchable base member 10 in the second direction.

Specifically, the distance between conductive members 20a, 20b and conductive member 20d in the second direction and the distance between conductive members 20b, 20c and conductive member 20e in the second direction are shorter than those in the first state. Also, the distance between conductive member 20d and conductive members 20f, 20g in the second direction, and the distance between conductive member 20e and conductive members 20g, 20h in the second direction are shorter than those in the first state.

Similarly, the distance between conductive members 20k, 201 and conductive member 20i in the second direction, and the distance between conductive members 201, 20m and conductive member 20j in the second direction are shorter than those in the first state. Also, the distance between conductive member 20i and conductive members 20f, 20g in the second direction, and the distance between conductive member 20j and conductive members 20g, 20h in the second direction are shorter than those in the first state.

In this way, the plurality of conductive members 20a to 20m are brought closer to each other in the second direction, thereby forming a conductive path, for example, as shown by a dashed arrow line.

When stretchable base member 10 is expanded in the first direction, the width of stretchable base member 10 in the second direction is decreased. Thus, in the portion of stretchable base member 10 where its width is decreased, the electrical resistance of stretchable base member 10 in the expanding direction is increased. In this case, in elastic conductor 1 according to the present embodiment, the conductive path as described above is formed, thereby offsetting the increase in electrical resistance of stretchable base member 10 to a considerable degree. Accordingly, it becomes possible to suppress an increase in the entire electrical resistance of elastic conductor 1.

As described above, in elastic conductor 1 according to the present embodiment, it becomes possible to suppress an increase in electrical resistance caused by an increase in path length when elastic conductor 1 is expanded in a prescribed direction.

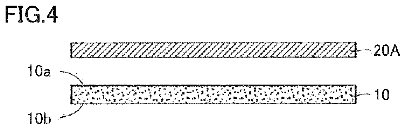

Figs. 4 to 8 show cross-sectional views illustrating the first step to the fifth step, respectively, of a method of manufacturing an elastic conductor according to the present embodiment. Referring to Figs. 4 to 8, the method of manufacturing elastic conductor 1 according to the present embodiment will be hereinafter described.

As shown in Fig. 4, in the first step of the method of manufacturing elastic conductor 1, a stretchable base member 10 and a conductive member precursor body 20A are prepared. Stretchable base member 10 to be used is, for example, obtained by adding a carbon filler to SEBS as described above. Conductive member precursor body 20A to be used is, for example, a sheet-shaped copper foil having a roughened main surface on one side.

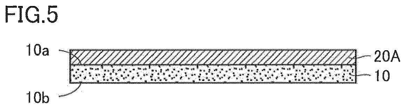

As shown in Fig. 5, in the second step of the method of manufacturing elastic conductor 1, stretchable base member 10 and conductive member precursor body 20A are arranged to face each other such that roughened main surface faces stretchable base member 10. Then, the resultant is subjected to thermocompression-bonding at a temperature of about 120 °C to 180 °C.

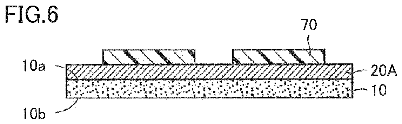

As shown in Fig. 6, in the third step of the method of manufacturing elastic conductor 1, a photoresist is applied, and then, exposure and development are conducted, thereby forming a resist pattern 70. Resist pattern 70 has a shape corresponding to a plurality of conductive members.

The material, the film thickness and the formation method of a photoresist may be optional. Also, a positive-type photoresist may be used or a negative-type photoresist may be used.

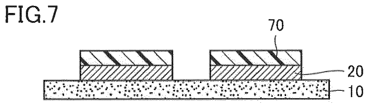

As shown in Fig. 7, in the fourth step of the method of manufacturing elastic conductor 1, conductive member precursor body 20A is etched using an etching solution to form a plurality of conductive members 20a to 20m on a surface 10a of stretchable base member 10. The etching solution to be used is a ferric chloride solution, for example.

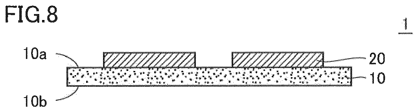

As shown in Fig. 8, in the fifth step of the method of manufacturing elastic conductor 1, resist pattern 70 is removed to produce elastic conductor 1.

### (Second Embodiment)

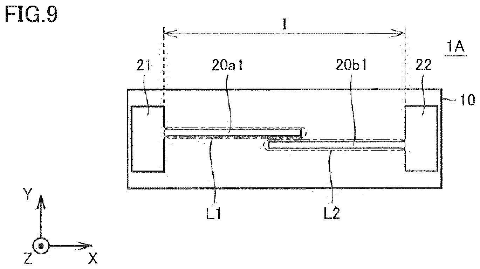

Fig. 9 is a plan view of an elastic conductor according to the present embodiment. Referring to Fig. 9, an elastic conductor 1A according to the present embodiment will be hereinafter described.

As shown in Fig. 9, elastic conductor 1A according to the present embodiment is different from elastic conductor 1 according to the first embodiment in that pattern shapes of a plurality of conductive members and electrode portions 21 and 22 are provided.

The plurality of conductive members 20a1 and 20b1 are arranged to be spaced apart from each other in the second direction perpendicular to the first direction, and to be continuous in at least a partial section I extending in the first direction as seen in the second direction from one end of partial section I to the other end of partial section I in the first direction. At least a partial section I used herein means, for example, a section between electrode portions 21 and 22 provided on the one end side and the other end side, respectively, of stretchable base member 10 in the first direction.

One end of conductive member 20a1 in the first direction is connected to electrode portion 21 provided on the one end side of stretchable base member 10 in the first direction. The other end side of conductive member 20a1 in the first direction faces, in the second direction, the one end side of conductive member 20b1 in the first direction. The other end of conductive member 20a1 in the first direction is located closer to the other end of conductive member 20b1 in the first direction than one end of conductive member 20b1 in the first direction is.

The one end side of conductive member 20b1 in the first direction faces, in the second direction, the other end side of conductive member 20a in the first direction. The other end of conductive member 20b1 is connected to electrode portion 22 provided on the other end side of stretchable base member 10 in the first direction.

Each of electrode portions 21 and 22 has an approximately rectangular shape having a short side direction corresponding to the first direction and a long side direction corresponding to the second direction. Electrode portions 21 and 22 are electrically connected to an interconnection member and the like.

Also in the configuration as described above, in the second state in which tensile force acts in the first direction to cause elastic conductor 1 to be expanded in the first direction, stretchable base member 10 having a low modulus of elasticity extends in the first direction while suppressing deformation of the plurality of conductive members 20a1 and 20b1 each having a high modulus of elasticity. Accordingly, the distance between conductive members 20a1 and 20b1 in the second direction is shorter than that in the first state in which tensile force does not act in the first direction.

Thus, in the second state, a conductive path is formed so as to pass through conductive members 20a1 and 20b1 that are located close to each other as in the first embodiment.

Thus, even if stretchable base member 10 is expanded in the first direction and reduced in width in the second direction to thereby increase the electrical resistance of stretchable base member 10 in the first direction, the increased electrical resistance of stretchable base member 10 is offset to a considerable degree due to formation of a conductive path. Thereby, it becomes possible to suppress an increase in the entire electrical resistance of elastic conductor 1. Consequently, also in elastic conductor 1A according to the present embodiment, it becomes possible to suppress an increase in electrical resistance caused by an increase in path length when this elastic conductor 1A is expanded in a prescribed direction.

### (Third Embodiment)

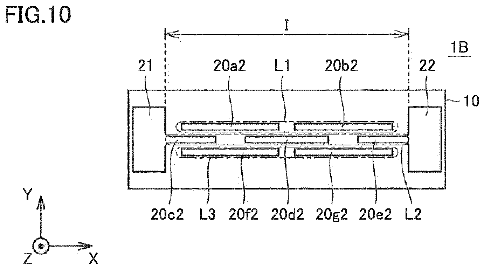

Fig. 10 is a plan view of an elastic conductor according to the present embodiment. Referring to Fig. 10, an elastic conductor 1B according to the present embodiment will be hereinafter described.

As shown in Fig. 10, elastic conductor 1B according to the present embodiment is different from elastic conductor 1 according to the first embodiment in that pattern shapes of a plurality of conductive members and electrode portions 21 and 22 are provided.

A plurality of conductive members 20a2 to 20g2 are arranged to be spaced apart from each other in the second direction perpendicular to the first direction, and to be continuous in at least a partial section I extending in the first direction as seen in the second direction from one end of partial section I to the other end of partial section I in the first direction.

The plurality of conductive members 20a2 to 20g2 are arranged in a staggered manner. Some conductive members of the plurality of conductive members 20a2 to 20g2 are linearly arranged to be spaced apart from each other in the first direction, to thereby form a first line L1 to a third line L3. First line L1 to third line L3 are sequentially arranged side by side to be spaced apart from each other in the Y-axis direction. Second line L2 is located in the center portion of stretchable base member 10 in the second direction.

First line L1 and third line L3 have almost the same configuration. First line L1 includes conductive members 20a2 and 20b2. Conductive members 20a2 and 20b2 are linearly arranged to be spaced apart from each other in the first direction. Third line L3 includes conductive members 20f2 and 20g2. Conductive members 20f2 and 20g2 are linearly arranged to be spaced apart from each other in the first direction.

Conductive members 20a2 and 20f2 are located on the one end side of section I. Conductive members 20a2 and 20f2 have almost the same length. One ends of conductive members 20a2 and 20f2 in the first direction overlap with each other as seen in the second direction. The other ends of conductive members 20a2 and 20f2 in the first direction overlap with each other as seen in the second direction. Conductive members 20a2 and 20f2 are arranged side by side to be spaced apart from each other in the second direction.

Conductive members 20b2 and 20g2 are located on the one end side of section I. Conductive members 20b2 and 20g2 have almost the same length. One ends of conductive members 20b2 and 20g2 in the first direction overlap with each other as seen in the second direction. The other ends of conductive members 20b2 and 20g2 in the first direction overlap with each other as seen in the second direction. Conductive members 20b2 and 20g2 are arranged side by side to be spaced apart from each other in the second direction.

Second line L2 includes conductive members 20c2, 20d2 and 20e2. Conductive members 20c2, 20d2 and 20e2 are linearly arranged to be spaced apart from each other in the first direction.

One end of conductive member 20c2 in the first direction is connected to electrode portion 21. The other end side of conductive member 20c2 in the first direction is located between conductive members 20a2 and 20f2 in the second direction. The other end of conductive member 20c2in the first direction is located closer to one ends of conductive members 20a2 and 20f2 than the center portions of conductive members 20a2 and 20f2 are.

The one end side of conductive member 20d2 is located between conductive members 20a2 and 20f2 in the second direction. One end of conductive member 20d2 is located closer to the other ends of conductive members 20a2 and 20f2 than the center portions of conductive members 20a2 and 20f2 are.

The other end side of conductive member 20d2 is located between conductive members 20b2 and 20g2 in the second direction. The other end of conductive member 20d2 is located closer to one ends of conductive members 20b2 and one 20g2 in the first direction than the center portions of conductive members 20b2 and 20g2 are.

The one end side of conductive member 20e2 is located between conductive members 20b2 and 20g2. One end of conductive member 20e2 is located closer to the other ends of conductive members 20b2 and 20g2 in the first direction than the center portions of conductive members 20b2 and 20g2 are. The other end of conductive member 20e2 is connected to electrode portion 22.

Also in the configuration as described above, in the second state in which tensile force acts in the first direction to cause elastic conductor 1 to be expanded in the first direction, stretchable base member 10 having a low modulus of elasticity extends in the first direction while suppressing deformation of the plurality of conductive members 20a2 to 20g2 each having a high modulus of elasticity. Accordingly, as compared with the first state in which tensile force does not act in the first direction, the distance between the conductive members in the first direction is increased and the distance between the conductive members in the second direction is decreased.

Specifically, in first line L1, the distance between conductive members 20a2 and 20b2 in the first direction is increased. In second line L2, the distance between conductive members 20c2 and 20d2 in the first direction is increased, and the distance between conductive members 20d2 and 20e2 in the first direction is increased. In third line L3, the distance between conductive members 20f2 and 20g2 in the first direction is increased.

On the other hand, first line L1 and third line L3 are brought closer to second line L2 located in the center portion of stretchable base member 10 in the second direction.

Specifically, the distance between conductive member 20a2 and conductive members 20c2, 20d2 in the second direction is reduced, and the distance between conductive member 20b2 and conductive members 20d2, 20e2 in the second direction is reduced. Also, the distance between conductive members 20c2, 20d2 and conductive member 20f2 in the second direction is reduced, and the distance between conductive members 20d2, 20e2 and conductive member 20g2 in the second direction is reduced.

Thereby, a conductive path is formed so as to cause a current to flow through conductive members 20c2, 20a2, 20d2, 20b2, and 20e2 that are located in close proximity to each other, and a conductive path is formed so as to cause a current to flow through conductive members 20c2, 20f2, 20d2, 20g2, and 20e2 that are located in close proximity to each other.

Thus, even if stretchable base member 10 is expanded in the first direction and reduced in width in the second direction to thereby increase the electrical resistance of stretchable base member 10 in the first direction, the increased electrical resistance of stretchable base member 10 is offset to a considerable degree due to formation of a conductive path. Thereby, it becomes possible to suppress an increase in the entire electrical resistance of elastic conductor 1. Consequently, also in elastic conductor 1B according to the present embodiment, it becomes possible to suppress an increase in electrical resistance caused by an increase in path length when this elastic conductor 1B is expanded in a prescribed direction.

In addition, elastic conductor 1B according to the present embodiment is greater in number of conductive paths than elastic conductor 1A according to the second embodiment. Thus, it becomes possible to further suppress an increase in the entire electrical resistance of elastic conductor 1.

### (Fourth Embodiment)

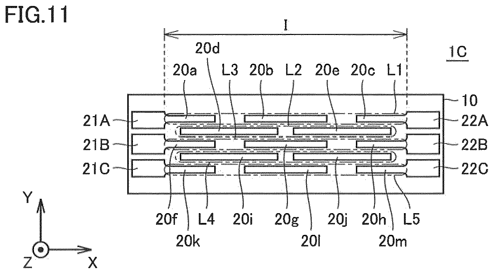

Fig. 11 is a plan view of an elastic conductor according to the present embodiment. Referring to Fig. 11, an elastic conductor 1C according to the present embodiment will be hereinafter described.

As shown in Fig. 11, elastic conductor 1C according to the present embodiment is different from elastic conductor 1 according to the first embodiment in that electrode portions 21A to 21C and 22A to 22C are provided.

Electrode portions 21A, 21B and 21C are arranged to be spaced apart from each other in the second direction. Electrode portions 22A, 22B and 22C are arranged to be spaced apart from each other in the second direction.

At least any of electrode portions 21A, 21B and 21C is electrically connected to an interconnection member and the like. At least any of electrode portions 22A, 22B and 22C is electrically connected to an interconnection member and the like.

In this way, electrode portions 21A to 21C are arranged to be spaced apart from each other in the second direction, and electrode portions 22A to 22C are arranged to be spaced apart from each other in the second direction. Thus, when stretchable base member 10 is expanded in the first direction, electrode portions 21A to 21C can be brought closer to each other while electrode portions 22A to 22C can be brought closer to each other.

In the case where electrode portions 21A to 21C are not spaced apart from each other but formed as an integral electrode portion and electrode portions 22A to 22C are not spaced apart from each other but formed as an integral electrode portion, contraction of stretchable base member 10 in the second direction is suppressed in the vicinity of each of the integral electrode portions when stretchable base member 10 is expanded in the first direction. Thereby, the one end side of conductive member 20a in the first direction and the other end side of conductive member 20c in the first direction are less likely to be closer to conductive member 20f and conductive member 20h, respectively.

In this case, in the present embodiment, electrode portions 21A to 21C are brought closer to each other, and electrode portions 22A to 22C are brought closer to each other. Thereby, conductive member 20a connected to electrode portion 21A can be entirely moved toward conductive member 20f while conductive member 20c connected to electrode portion 22A can be entirely moved toward conductive member 20h.

Furthermore, conductive member 20k connected to electrode portion 21C can be entirely moved toward conductive member 20i while conductive member 20m connected to electrode portion 22C can be entirely moved toward conductive member 20j.

Thereby, in the second state in which stretchable base member 10 is expanded in the first direction, the above-described conductive path can be reliably formed. Due to formation of a conductive path, even if stretchable base member 10 is expanded in the first direction and reduced in width in the second direction to thereby increase the electrical resistance of stretchable base member 10 in the first direction, the increased electrical resistance of stretchable base member 10 is offset to a considerable degree. Thereby, it becomes possible to suppress an increase in the entire electrical resistance of elastic conductor 1. Consequently, also in elastic conductor 1C according to the present embodiment, it becomes possible to suppress an increase in electrical resistance caused by an increase in path length when this elastic conductor 1C is expanded in a prescribed direction.

In addition, elastic conductor 1C according to the present embodiment is greater in line number in the second direction than elastic conductor 1B according to the third embodiment. Thus, the number of conductive paths formed in the second state increases. Thereby, in elastic conductor 1C according to the present embodiment, it becomes possible to more suppress an increase in the entire electrical resistance of elastic conductor 1 than in elastic conductor 1B according to the third embodiment.

### (Fifth Embodiment)

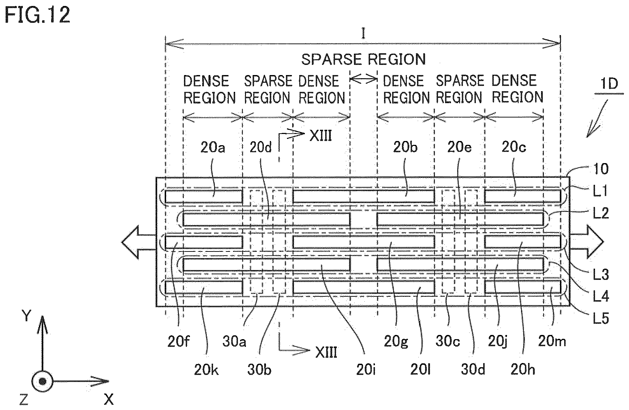

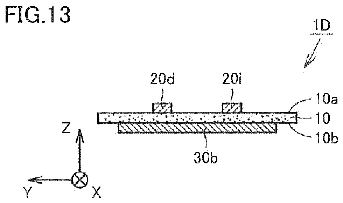

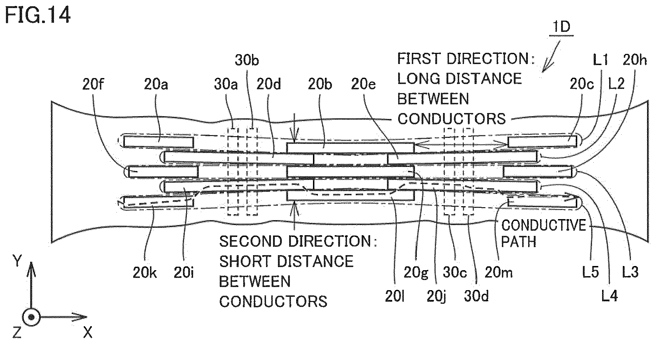

Fig. 12 is a plan view of an elastic conductor according to the present embodiment. Fig. 13 is a cross-sectional view taken along a line XIII-XIII shown in Fig. 12. Fig. 14 is a diagram showing the state in which the elastic conductor according to the present embodiment is tensioned in the first direction. Referring to Figs. 12 to 14, an elastic conductor ID according to the present embodiment will be hereinafter described.

As shown in Figs. 12 to 14, elastic conductor ID according to the present embodiment is different from elastic conductor 1 according to the first embodiment in that restraint members 30a to 30d are provided.

In section I where a plurality of conductive members 20a to 20m are provided, some conductive members of the plurality of conductive members 20a to 20m are arranged side by side in the second direction, to thereby form: a dense region where the conductive members along the width of stretchable base member 10 in the second direction are dense in number; and a sparse region where the conductive members along the width of stretchable base member 10 in the second direction are more sparse in number than the dense region.

Restraint members 30a to 30d are provided on a back surface 10b of stretchable base member 10 on the opposite side of a surface 10a of stretchable base member 10 on which the plurality of conductive members 20a to 20m are provided.

Restraint members 30a to 30d are higher in modulus of elasticity than stretchable base member 10, and configured to suppress expansion and contraction of stretchable base member 10 in the second direction. Each of restraint members 30a to 30d is configured to include a portion extending in the second direction. Each of restraint members 30a to 30d has a longitudinal shape extending in the second direction, for example. In addition, the shape of each of restraint members 30a to 30d is not limited to a longitudinal shape, but can be modified as appropriate.

Restraint members 30a to 30d are provided on back surface 10b of stretchable base member 10 so as to overlap with the above-mentioned sparse region as seen in the normal direction of surface 10a of stretchable base member 10. Each of restraint members 30a to 30d is formed of metal foil, for example. Restraint members 30a to 30d each may be formed of the same material as those of conductive members 20a to 20m, or may be formed of a material different from those of conductive members 20a to 20m. Furthermore, restraint members 30a to 30d each do not have to be a conductor, but may be formed of a highly elastic resin material such as polyimide.

By providing restraint members 30a to 30d, expansion of the width of stretchable base member 10 in the second direction can be suppressed even if stretchable base member 10 is expanded in the second direction due to force exerted also from the unintended direction when stretchable base member 10 is expanded in the first direction.

As described above, also in the present embodiment, in the second state in which tensile force acts in the first direction to cause elastic conductor 1D to be expanded in the first direction, the distance between the conductive members in the second direction is shorter than that in the first state, thereby forming a conductive path. Accordingly, the increase in electrical resistance of stretchable base member 10 occurring in the second state is offset to a considerable degree. Thus, it becomes possible to suppress an increase in the entire electric resistance of elastic conductor 1D. Consequently, it becomes possible to suppress an increase in electrical resistance caused by an increase in path length when this elastic conductor is expanded in a prescribed direction.

In addition, due to formation of restraint members 30a to 30d, as described above, even if stretchable base member 10 is expanded in the second direction by the force exerted also from the unintended direction when stretchable base member 10 is expanded in the first direction, expansion of the width of stretchable base member 10 in the second direction can be suppressed.

An elastic conductor 1E according to the present embodiment can be manufactured as follows. Specifically, metal foil as a conductive member precursor body and metal foil as a restraint member precursor body are thermocompression-bonded onto surface 10a and back surface 10b of stretchable base member 10, and then, the conductive member precursor body and the restraint member precursor body are patterned using the photolithography method as in the first embodiment.

When the conductive member precursor body and the restraint member precursor body are patterned, a through hole is formed in a stretchable substrate having both surfaces on which metal foils are compression-bonded such that the through hole penetrates through the substrate in its thickness direction from the metal foil on one side to the metal foil on the other side. Then, patterning is conducted using this through hole as an alignment mark, so that a conductive member and a restraint member can be formed with accuracy.

In addition, the conductive member precursor body, the restraint member precursor body and stretchable base member 10 having through holes penetrating therethrough in their thickness directions at the same position may be prepared. In this case, for example, in order to allow communication between the through holes provided in the conductive member precursor body, the restraint member precursor body and stretchable base member 10, specifically, by using each through hole as a positioning mark, the conductive member precursor body, the restraint member precursor body and stretchable base member 10 are stacked on one another and thermocompression-bonded. Thereby, the conductive member precursor body and the restraint member precursor body can be accurately fixed to stretchable base member 10 while preventing the positional misalignment between the conductive member precursor body and the restraint member precursor body. In addition, a positioning pin may be inserted through each through hole as required for fixation.

This also allows accurate patterning of the conductive member precursor body and the restraint member precursor body, so that a plurality of conductive members 20a to 20m and restraint members 30a to 30d can be formed with accuracy.

### (Sixth Embodiment)

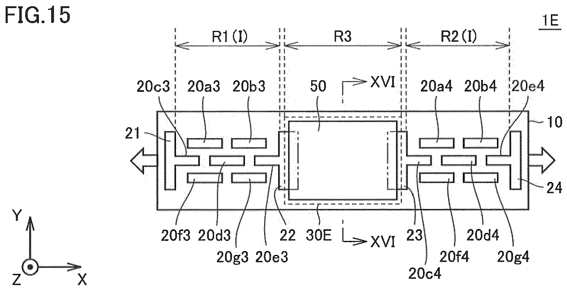

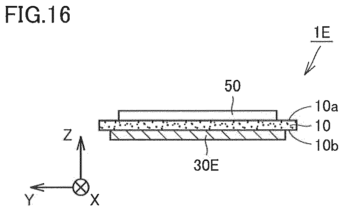

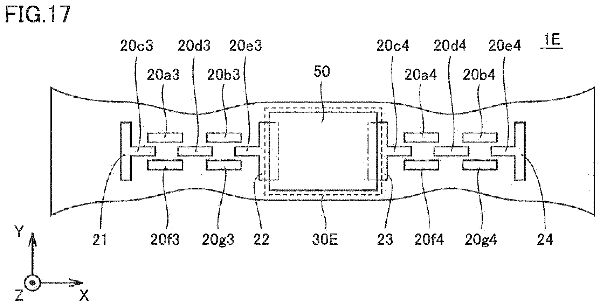

Fig. 15 is a plan view of an elastic conductor according to the present embodiment. Fig. 15 is a diagram showing the state before the elastic conductor is tensioned in the first direction. Fig. 16 is a cross-sectional view taken along a line XVI-XVI shown in Fig. 15. Fig. 17 is a diagram showing the state in which the elastic conductor according to the present embodiment is tensioned in the first direction. Referring to Figs. 15 to 17, elastic conductor 1E according to the present embodiment will be hereinafter described.

As shown in Figs. 15 to 17, elastic conductor 1E according to the present embodiment is different from elastic conductor 1 according to the first embodiment in that a circuit substrate 50 as an electronic component is provided on the surface of stretchable base member 10, and in that a restraint member 30E is provided on the back surface of stretchable base member 10 corresponding to the surface on which circuit substrate 50 is provided. Circuit substrate 50 is illustrated as an electronic component, though not limited thereto. Alternatively, surface-mounted components such as a capacitor and a chip coil, elements having bumps such as an IC, and the like may also be used.

A plurality of conductive members are provided in a first region R1 and a second region R2. Each of first region R1 and second region R2 forms at least a partial section I in stretchable base member 10 extending in the first direction. First region R1 and second region R2 are arranged to be spaced apart from each other in the second direction. An electronic component mounted region R3 on which an electronic component is mounted is provided on the surface of stretchable base member 10 located between first region R1 and second region R2.

A plurality of conductive members 20a3 to 20g3 are provided in first region R1. The plurality of conductive members 20a3 to 20g3 are arranged in the layout relation almost similar to that of the plurality of conductive members 20a2 to 20g2 according to the third embodiment.

One end of conductive member 20c3 in the first direction is connected to electrode portion 21. The other end of conductive member 20e3 in the first direction is connected to electrode portion 22.

A plurality of conductive members 20a4 to 20g4 are provided in second region R2. The plurality of conductive members 20a4 to 20g4 are arranged in the layout relation almost similar to that of the plurality of conductive members 20a2 to 20g2 according to the third embodiment.

One end of conductive member 20c4 in the first direction is connected to electrode portion 23. The other end of conductive member 20e4 in the first direction is connected to electrode portion 24.

Circuit substrate 50 has terminal portions on both ends in the first direction. The terminal portions of circuit substrate 50 are connected to electrode portion 22 and electrode portion 23 with solder or the like. The region between one end of electrode portion 22 in the first direction and the other end of electrode portion 23 in the first direction corresponds to electronic component mounted region R3.

Restraint member 30E is provided on back surface 10b of stretchable base member 10 so as to overlap with electronic component mounted region R3 as seen in the normal direction of surface 10a of stretchable base member 10. Restraint member 30E is higher in modulus of elasticity than stretchable base member 10, and configured to suppress expansion and contraction of stretchable base member 10 in the second direction.

Restraint member 30E has a rectangular shape, for example. In addition, the shape of restraint member 30E is not limited to a rectangular shape as long as it can suppress expansion and contraction of stretchable base member 10 in the second direction, but may be a polygonal shape, a circular shape, a frame shape, a lattice shape, and the like.

Restraint member 30E may be formed of the same material as the plurality of conductive members 20a3 to 20g3 and 20a4 to 20g4, or may be formed of different materials. Furthermore, restraint member 30E does not have to be a conductor, but may be formed of a highly elastic resin material such as polyimide, an epoxy resin and the like. When restraint member 30E is formed of a highly elastic resin material, an adhesive or the like may be used in order to achieve adhesive contact between the stretchable base member and the restraint member.

By providing restraint member 30E in this way, as shown in Fig. 17, when stretchable base member 10 is expanded in the first direction, expansion and contraction of stretchable base member 10 in the second direction in a portion corresponding to electronic component mounted region R3 can be suppressed while bringing the plurality of conductive members 20a3 to 20g3 closer to each other in the second direction in first region R1 and bringing the plurality of conductive members 20a4 to 20g4 closer to each other in the second direction in second region R2. In addition, restraint member 30E can suppress expansion and contraction of stretchable base member 10 not only in the second direction but also in any direction.

As described above, also in the present embodiment, in the second state in which tensile force acts in the first direction to cause elastic conductor 1 to be expanded in the first direction, the distance between the conductive members in the second direction is shorter than that in the first state, thereby forming a conductive path. Thus, the increase in electrical resistance of stretchable base member 10 occurring in the second state is offset to a considerable degree. Thereby, it becomes possible to suppress an increase in the entire electrical resistance of elastic conductor 1. Consequently, it becomes possible to suppress an increase in electrical resistance caused by an increase in path length when elastic conductor 1 is expanded in a prescribed direction.

Furthermore, expansion and contraction of the width of stretchable base member 10 in the second direction in a portion corresponding to electronic component mounted region R3 can be suppressed, so that it becomes possible to suppress separation of circuit substrate 50 from the surface of stretchable base member 10.

Elastic conductor 1E according to the present embodiment can be manufactured based on the method of manufacturing elastic conductor ID according to the fifth embodiment. Circuit substrate 50 is fixed to electrode portions 22 and 23 with solder or the like after the plurality of conductive members and restraint member 30E are formed.

Elastic conductor 1E according to the present embodiment has been described with reference to the case where first region R1, second region R2 and electronic component mounted region R3 are formed, but not limited thereto, and may be a configuration in which first region R1 and electronic component mounted region R3 are provided but second region R2 is not provided. In this case, it is preferable that electronic component mounted region R3 is provided so as to be adjacent to first region R1. Such a configuration can also achieve the effect similar to the above.

Also, the present embodiment has been described with reference to the case where restraint member 30E is provided on back surface 10b of stretchable base member 10 so as to overlap with electronic component mounted region R3 as seen in the normal direction of surface 10a of stretchable base member 10, but not limited thereto, and may be provided inside stretchable base member 10.

### (Seventh Embodiment)

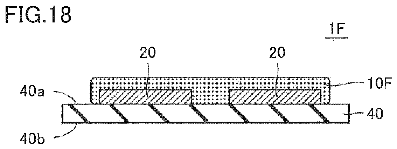

Fig. 18 is a plan view of an elastic conductor according to the present embodiment. Referring to Fig. 18, an elastic conductor 1F according to the present embodiment will be hereinafter described.

As shown in Fig. 18, elastic conductor 1F according to the present embodiment is different from elastic conductor 1 according to the first embodiment in that it includes a plurality of conductive members 20, a stretchable base member 10F having conductivity and an elastic base member 40 configured to support these members, and also in that the plurality of conductive members 20 are provided inside stretchable base member 10F.

Elastic base member 40 has a plate shape. Elastic base member 40 has a first main surface 40a and a second main surface 40b that face in opposite directions. Elastic base member 40 is formed so as to be stretchable. Elastic base member 40 is formed, for example, of thermoplastic elastomer such as SEBS.

The plurality of conductive members 20 are provided on first main surface 40a of elastic base member 40. The plurality of conductive members 20 have almost the same configuration as that in the first embodiment, for example. The plurality of conductive members 20 are higher in modulus of elasticity than elastic base member 40 and stretchable base member 10F. The plurality of conductive members 20 each are, for example, formed of a single-phase metal foil made of Cu, Ag, Au, Ni, Zn, Al, Sn and the like, or formed of metal foil made of an alloy containing at least some of these metals.

The material of the metal foil is not particularly limited, but preferably has a specific resistance equal to or less than 10⁻⁵ Ω•m. It is preferable that the material of the metal foil is metal mainly containing Cu in consideration of versatility, cost and the like. For the purpose of preventing oxidation, the surfaces of the plurality of conductive members 20 may be subjected to surface treatment such as NiAu plating or NiPdAu plating.

The plurality of conductive members 20 may be formed by a subtractive method, or may be formed by an additive method using plating growth or the like, or by a method of transferring pre-patterned metal foil.

Stretchable base member 10F is provided on first main surface 40a of elastic base member 40 so as to cover the plurality of conductive members 20. Stretchable base member 10F has conductivity and is formed so as to be stretchable. Stretchable base member 10F only has to be a stretchable conductor, and may be formed using: a material obtained by kneading a conductive polymer or resin represented by polyacetylene, polyphenylene, polyphenylene vinylene, polypyrrole, polythiophene, polyethylene dioxythiophene (PEDOT), polyaniline, polyacene, graphene, and the like with a one-dimensional conductor represented by an Ag nanowire and a carbon nanotube; conductive rubber obtained by kneading thermoplastic elastomer with carbon or metal filler; and the like. Stretchable base member 10F may be formed of a material obtained by kneading a stretchable resin material with particulate or flat-shaped metal filler. Metal filler may be formed using Ag, Cu, Al, Ni, Sn, Zn, or an alloy made of two or more of these metals.

Also in the configuration as described above, in the second state in which tensile force acts in the first direction to cause elastic conductor 1F to be expanded in the first direction, the distance between the conductive members in the second direction is shorter than that in the first state, so that a conductive path is formed. Due to formation of a conductive path, the increase in electrical resistance of stretchable base member 10 occurring in the second state is offset to a considerable degree. Thereby, it becomes possible to suppress an increase in the entire electrical resistance of elastic conductor 1. Consequently, elastic conductor 1F according to the present embodiment can suppress an increase in electrical resistance caused by an increase in path length when this elastic conductor 1F is expanded in a prescribed direction.

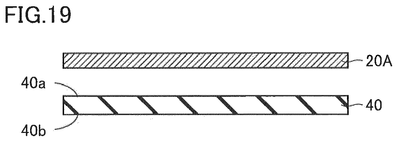

Figs. 19 to 24 are diagrams showing the first step to the sixth step, respectively, of a method of manufacturing an elastic conductor according to the present embodiment. Referring to Figs. 19 to 24, the method of manufacturing an elastic conductor according to the present embodiment will be hereinafter described.

As shown in Fig. 19, in the first step of the method of manufacturing elastic conductor IF, an elastic base member 40 and a conductive member precursor body 20A are prepared. Elastic base member 40 to be used is a seat-shaped SEBS. Conductive member precursor body 20A to be used is, for example, a sheet-shaped copper foil having a roughened main surface on one side.

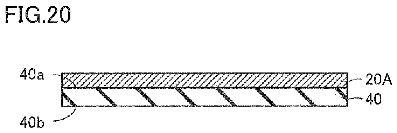

As shown in Fig. 20, in the second step of the method of manufacturing elastic conductor IF, elastic base member 40 and conductive member precursor body 20A are arranged to face each other such that roughened main surface faces elastic base member 40, which are then thermocompression-bonded at a temperature of about 120°C to 180°C.

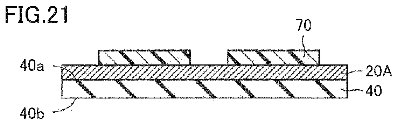

As shown in Fig. 21, in the third step of the method of manufacturing elastic conductor IF, a photoresist is applied, and then, exposure and development are conducted, thereby forming a resist pattern 70. Resist pattern 70 has a shape corresponding to a plurality of conductive members.

The material, the film thickness and the formation method of a photoresist may be optional. Also, a positive-type photoresist may be used or a negative-type photoresist may be used.

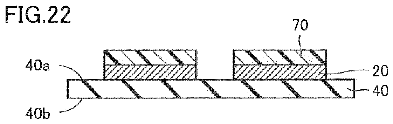

As shown in Fig. 22, in the fourth step of the method of manufacturing elastic conductor 1F, conductive member precursor body 20A is etched using an etching solution, to form a plurality of conductive members 20a to 20m on a first main surface 40a of elastic base member 40. The etching solution to be used may be a ferric chloride solution, for example.

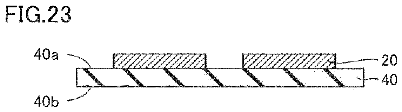

As shown in Fig. 23, in the fifth step of the method of manufacturing elastic conductor 1, resist pattern 70 is removed to produce a plurality of conductive members 20.

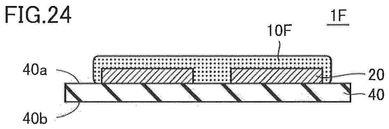

As shown in Fig. 24, in the sixth step of the method of manufacturing elastic conductor 1F, a conductive paste mainly made of Ag filler is applied over first main surface 40a of elastic base member 40 so as to cover the plurality of conductive members 20. Then, the applied conductive paste is dried under the environment at a temperature of 80 °C to 150 °C, to form stretchable base member 10F having stretchability. Thereby, elastic conductor 1F is manufactured.

In addition, an elastic conductor corresponding to each of the elastic conductors according to the first to sixth embodiments can be manufactured based on the method of manufacturing elastic conductor 1F according to the present embodiment. The elastic conductor corresponding to each of the elastic conductors according to the first to sixth embodiments is obtained by forming, on an elastic base member, pattern shapes identical to those of the plurality of conductive members according to each of the first to sixth embodiments, and then covering the formed pattern shapes with a stretchable base member.

For example, the elastic conductor corresponding to the fifth embodiment includes a restraint member that is higher in modulus of elasticity than elastic base member 40 and configured to restrain expansion and contraction of elastic base member 40 in the second direction. In at least a partial section I corresponding to the fifth embodiment, some conductive members of the plurality of conductive members are arranged side by side in the second direction to thereby form: a dense region where the conductive members along the width of the stretchable base member in the second direction are dense in number; and a sparse region where the conductive members along the width of the stretchable base member in the second direction are more sparse in number than the dense region. The restraint member is provided on the second main surface so as to overlap with the sparse region as seen in the normal direction of second main surface 40a of elastic base member 40.

Furthermore, the elastic conductor corresponding to the sixth embodiment includes a restraint member that is higher in modulus of elasticity than elastic base member 40 and configured to suppress expansion of elastic base member 40 in the second direction. On the surface of the stretchable base member adjacent to at least a partial section 1 corresponding to the sixth embodiment, an electronic component mounted region having an electronic component mounted thereon is provided. The restraint member is provided on the second main surface or inside elastic base member 40 so as to overlap with the electronic component mounted region as seen in the normal direction of the second main surface.

### (Verification Experiment)

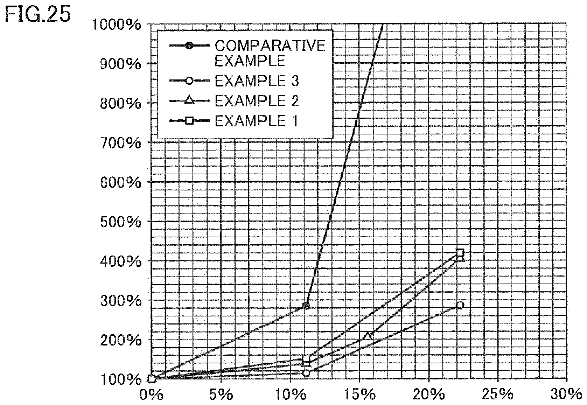

Fig. 25 is a diagram showing conditions and results of a verification experiment performed for verifying the effect of the present invention. Referring to Fig. 25, the conditions and results of the verification experiment performed for verifying the effect of the present invention will be hereinafter described. In Fig. 25, the vertical axis shows the resistance of the elastic conductor while the horizontal axis shows expansion of the elastic conductor in the first direction.

As shown in Fig. 25, for verifying the effect of the present invention, an elastic conductor in Comparative Example 1 and elastic conductors according to Examples 1 to 3 were prepared. An elastic conductor used in Comparative Example 1 was an elastic conductor: not provided with a plurality of conductive members; but having electrode portions provided on both ends of a stretchable base member having stretchability. As an elastic conductor according to Example 1, the elastic conductor according to the second embodiment was used. As an elastic conductor according to Example 2, the elastic conductor according to the third embodiment was used. As an elastic conductor according to Example 3, the elastic conductor according to the fourth embodiment was used. As described above, the number of conductive paths formed in the second state is increased sequentially in order of Example 1, Example 2 and Example 3 so as to correspond to the second embodiment, the third embodiment and the fourth embodiment.

Then, the resistance changes were measured, which occurred when the elastic conductor in Comparative Example 1 and the elastic conductors according to Examples 1 to 3 were expanded in the first direction. In this case, the electrical resistances of the elastic conductor according to Comparative Example 1 and the elastic conductors according to Examples 1 to 3 in the first state were set to be the same value.

In Comparative Example 1, the electrical resistance increased as the elastic conductor was expanded in the first direction. Then, in the state in which the elastic conductor was expanded by 11%, the electrical resistance reached a value that was about 2.8 times as high as the value in the first state. When the elastic conductor was expanded over 11%, the electrical resistance abruptly increased.

In Examples 1 to 3, the electrical resistance increased as the elastic conductor was expanded in the first direction, but the increased amount was reduced as compared with that in Comparative Example 1.

Example 1 showed a value that was about 1.5 times as high as that in the first state in the state in which the elastic conductor was expanded by 11%. Also, when the elastic conductor was expanded over 11%, the increase rate of the electrical resistance was increased, but reduced as compared with that in Comparative Example 1.

Example 2 showed a value that was about 1.4 times as high as that in the first state in the state in which the elastic conductor was expanded by 11%. Also, when the elastic conductor was expanded over 11%, the increase rate of the electrical resistance was increased, but reduced as compared with that in Comparative Example 1.

Example 3 showed a value that was about 1.2 times as high as that in the first state in the state in which the elastic conductor was expanded by 11%. Also, when the elastic conductor was expanded over 11%, the increase rate of the electrical resistance was increased, but reduced as compared with that in Comparative Example 1.

Based on the above-described results, it can be said that it was also experimentally confirmed that an increase in electrical resistance caused by expansion of the elastic conductor in the first direction can be suppressed by the following configuration. Specifically, a plurality of conductive members are arranged on a stretchable base member so as to be spaced apart from each other in the second direction perpendicular to the first direction, and to be continuous in at least a partial section extending in the first direction as seen in the second direction from one end of the partial section to the other end of the partial section in the first direction, in which the distance between the conductive members adjacent to each other in the second direction in the second state is shorter than the distance between the conductive members adjacent to each other in the second direction in the first state.

In the elastic conductors according to Examples 1 to 3, the conductive paths formed when tension is applied in the first direction are different in number, in which the number of the formed conductive paths is increased sequentially in order of Example 1, Example 2 and Example 3. The increase rate of the electrical resistance decreases sequentially in order of Example 1, Example 2 and Example 3. Thus, it can be said that it was also experimentally confirmed that the increase in the electrical resistance occurring upon expansion in the first direction can be further suppressed as the number of conductive paths increases.

### (First Use Example)

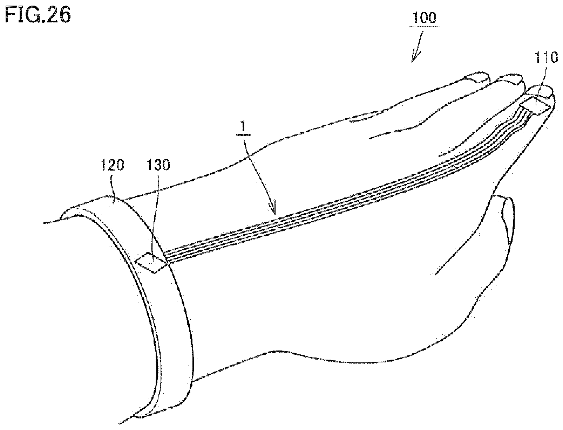

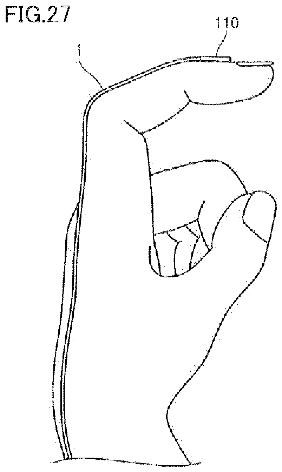

Figs. 26 and 27 are diagrams showing the first state and the second state, respectively, of the first use example of the elastic conductor according to the present invention.

As shown in Figs. 26 and 27, an elastic conductor 1 according to the present invention connects a sensor unit 110 provided at a user's fingertip and a control substrate 130 fixed to a wristband 120 wound around a user's wrist. The sensing result sensed by sensor unit 110 is input through elastic conductor 1 into a control unit provided in control substrate 130.

Sensor unit 110 is provided, for example, to be capable of sensing a body temperature and the like. As shown in Fig. 26, in the state in which the fingertip is extended, the tensile force in the first direction does not act on elastic conductor 1. As shown in Fig. 27, in the state in which the finger along which elastic conductor 1 is attached is bent, the tensile force in the first direction acts on the bent portion. Thereby, elastic conductor 1 is expanded in the first direction.

In such a case, the distance between the conductive members in the second direction is shorter than that in the first state, thereby forming a conductive path. Thus, the increase in electrical resistance caused by an increase in path length can be suppressed. Accordingly, when the body temperature is sensed by sensor unit 110 as described above, the body temperature can be sensed with stability.

### (Second Use Example)

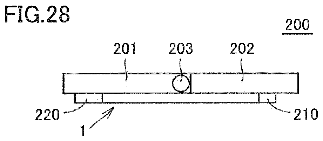

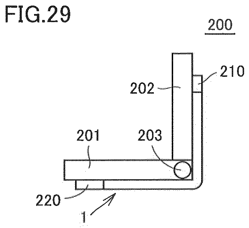

Figs. 28 and 29 are diagrams showing the first state and the second state, respectively, of the second use example of the elastic conductor according to the present invention.

As shown in Figs. 28 and 29, an elastic conductor 1 according to the present invention connects a sensor unit 210 provided on the tip end side of a movable arm unit 202 and a control substrate 220 provided on a fixed arm unit 201. The sensing result sensed by sensor unit 210 is input through elastic conductor 1 into a control unit provided in control substrate 220.

Movable arm unit 202 is fixed to fixed arm unit 201 by a hinge mechanism 203. Movable arm unit 202 is configured to be pivotable about the pivot axis extending in the direction perpendicular to the plane of the sheet of paper showing the figure.

Sensor unit 210 is provided, for example, to be capable of sensing a temperature, humidity and the like. As shown in Fig. 28, when movable arm unit 202 and fixed arm unit 201 are linearly arranged, elastic conductor 1 does not undergo tensile force in the first direction. As shown in Fig. 29, when movable arm unit 202 pivots about the pivot axis, the tensile force acts in the first direction corresponding to the direction in which elastic conductor 1 extends. Thereby, elastic conductor 1 is expanded in the first direction.

In such a case, the distance between the conductive members in the second direction is shorter than that in the first state, thereby forming a conductive path. Accordingly, the increase in electrical resistance caused by an increase in path length can be suppressed. Thus, when sensor unit 210 senses a temperature, humidity and the like as described above, the temperature and humidity and the like can be sensed with stability.

The elastic conductors according to the above embodiments have been described with reference to the case where the conductive member is formed of metal foil, though not limited thereto. Alternatively, the conductive member may be formed of a metal material in a bulk state. In this case, the metal material in a bulk state means a massive metal material made of hardened metal, but does not contain a metal material formed by drying a binder containing a large amount of metal particles such as a paste material.

Although the embodiments and examples of the present invention have been described as above, it should be understood that the embodiments and examples disclosed herein are illustrative and non-restrictive in every respect. The scope of the present invention is defined by the terms of the claims, and is intended to include any modifications within the meaning and scope equivalent to the terms of the claims.

### REFERENCE SIGNS LIST

1, 1A, 1B, 1C, ID, 1E, 1F elastic conductor, 10, 10F stretchable base member, 10a surface, 10b back surface, 20, 20a, 20a1, 20a2, 20a3, 20a4, 20b, 20b1, 20b2, 20c, 20c2, 20c3, 20c4, 20d, 20d2, 20e, 20e2, 20e3, 20f, 20f2, 20g, 20g2, 20g3, 20g4, 20h, 20i, 20j, 20k, 201, 20m conductive member, 20A conductive member precursor body, 21, 21A, 21B, 21C, 22, 22A, 22B, 22C, 23, 24 electrode portion, 30, 30E, 30a-30d restraint member, 40 elastic base member, 40a first main surface, 40b second main surface, 50 circuit substrate, 70 resist pattern, 110 sensor unit, 120 wristband, 130 control substrate, 201 fixed arm unit, 202 movable arm unit, 203 hinge mechanism, 210 sensor unit, 220 control substrate.

## Claims

1. An elastic conductor configured to be changeable between a first state before tensile force acts in a first direction and a second state in which the tensile force acts in the first direction to cause the elastic conductor to be expanded in the first direction, the elastic conductor comprising:
a stretchable base member (10, 10F) having conductivity; and
a plurality of conductive members (20, 20a-20m) each arranged on a surface of the stretchable base member (10, 10F) or inside the stretchable base member (10, 10F), each of the plurality of conductive members (20, 20a-20m) being lower in specific resistance and higher in modulus of elasticity than the stretchable base member (10, 10F),
**characterized in that**
in the first state, each of the plurality of conductive members (20, 20a-20m) has a longitudinal shape extending in the first direction,
in the first state, the plurality of conductive members (20, 20a-20m) being arranged to be spaced apart from each other in a second direction perpendicular to the first direction, and to be continuous in at least a partial section (I) extending in the first direction as seen in the second direction from one end of the partial section (I) to the other end of the partial section (I) in the first direction,
a distance between conductive members (20, 20a-20m) adjacent to each other in the second direction in the second state being shorter than a distance between conductive members (20, 20a-20m) adjacent to each other in the second direction in the first state, thereby forming a conductive path.

2. The elastic conductor according to claim 1, wherein each of the plurality of conductive members (20, 20a-20m) is formed of a metal material in a bulk state or metal foil.

3. The elastic conductor according to claim 1 or 2, further comprising a restraint member (30, 30E, 30a, 30d) that is higher in modulus of elasticity than the stretchable base member (10, 10F), the restraint member (30, 30E, 30a, 30d) being configured to suppress expansion and contraction of the stretchable base member (10, 10F) in the second direction, wherein
in the at least a partial section (I), two or more conductive members (20, 20a-20m) of the plurality of conductive members (20, 20a-20m) are arranged side by side in the second direction, to form a dense region and a sparse region, wherein
in the dense region the conductive members (20, 20a-20m) along a width of the stretchable base member (10, 10F) in the second direction are denser in number than in the sparse region; and
in the sparse region the conductive members (20, 20a-20m) along the width of the stretchable base member (10, 10F) in the second direction are sparser in number than in the dense region, and
the restraint member (30, 30E, 30a, 30d) is provided on a back surface of the stretchable base member (10, 10F) so as to overlap with the sparse region as seen in a normal direction of the surface of the stretchable base member (10, 10F).

4. The elastic conductor according to claim 1 or 2, further comprising a restraint member (30, 30E, 30a, 30d) that is higher in modulus of elasticity than the stretchable base member (10, 10F), the restraint member (30, 30E, 30a, 30d) being configured to suppress expansion and contraction of the stretchable base member (10, 10F) in the second direction, wherein
an electronic component mounted region (R3) having an electronic component (50) mounted thereon is provided on the surface of the stretchable base member (10, 10F), the surface being adjacent to the at least a partial section (I), and
the restraint member (30, 30E, 30a, 30d) is provided on a back surface of the stretchable base member (10, 10F) or inside the stretchable base member (10, 10F) so as to overlap with the electronic component mounted region (R3) as seen in a normal direction of the surface of the stretchable base member (10, 10F).

5. The elastic conductor according to claim 1 or 2, further comprising an elastic base member (40) having a first main surface (40a) and a second main surface (40b) that face in opposite directions, the elastic base member (40) being configured to support the stretchable base member (10, 10F) and the plurality of conductive members (20, 20a-20m), wherein
the plurality of conductive members (20, 20a-20m) are provided on the first main surface (40a), and
the stretchable base member (10, 10F) is provided on the first main surface (40a) to cover the plurality of conductive members (20, 20a-20m).

6. The elastic conductor according to claim 5, further comprising a restraint member (30, 30E, 30a, 30d) that is higher in modulus of elasticity than the elastic base member (40), the restraint member (30, 30E, 30a, 30d) being configured to restrain expansion and contraction of the elastic base member (40) in the second direction, wherein
in the at least a partial section (I), two or more conductive members (20, 20a-20m) of the plurality of conductive members (20, 20a-20m) are arranged side by side in the second direction, to form a dense region and a sparse region, wherein:
in the dense region the conductive members (20, 20a-20m) along a width of the stretchable base member (10, 10F) in the second direction are denser in number than in the sparse region; and
in the sparse region the conductive members (20, 20a-20m) along the width of the stretchable base member (10, 10F) in the second direction are sparser in number than in the dense region, and
the restraint member (30, 30E, 30a, 30d) is provided on the second main surface (40b) so as to overlap with the sparse region as seen in a normal direction of the second main surface (40b).

7. The elastic conductor according to claim 5, further comprising a restraint member (30, 30E, 30a, 30d) that is higher in modulus of elasticity than the elastic base member (40), the restraint member (30, 30E, 30a, 30d) being configured to suppress expansion of the elastic base member (40) in the second direction, wherein
an electronic component mounted region (R3) having an electronic component (50) mounted thereon is provided on the surface of the stretchable base member (10, 10F), the surface being adjacent to the at least a partial section (I), and
the restraint member (30, 30E, 30a, 30d) is provided so as to overlap with the electronic component mounted region (R3) as seen in a normal direction of the second main surface (40b).

## Patentansprüche

1. Ein elastischer Leiter, der dazu konfiguriert ist, zwischen einem ersten Zustand, bevor eine Zugkraft in einer ersten Richtung wirkt, und einem zweiten Zustand, in dem die Zugkraft in der ersten Richtung wirkt, wechseln zu können, um zu bewirken, dass der elastische Leiter in der ersten Richtung erweitert wird, wobei der elastische Leiter folgende Merkmale aufweist:
ein dehnbares Basisbauglied (10, 10F) mit Leitfähigkeit; und
eine Mehrzahl von leitfähigen Baugliedern (20, 20a-20m), die jeweils auf einer Oberfläche des dehnbaren Basisbauglieds (10, 10F) oder innerhalb des dehnbaren Basisbauglieds (10, 10F) angeordnet sind, wobei jedes der Mehrzahl von leitfähigen Baugliedern (20, 20a-20m) einen niedrigeren spezifischen Widerstand und einen höheren Elastizitätsmodul als das dehnbare Basisbauglied (10, 10F) aufweist,
**dadurch gekennzeichnet, dass**
in dem ersten Zustand jedes der Mehrzahl von leitfähigen Baugliedern (20, 20a-20m) eine Längsform aufweist, die sich in der ersten Richtung erstreckt,
in dem ersten Zustand die Mehrzahl von leitfähigen Baugliedern (20, 20a-20m) dahin gehend angeordnet ist, voneinander in einer zweiten Richtung, die senkrecht zu der ersten Richtung ist, beabstandet zu sein, und in zumindest einem Teilabschnitt (I) fortlaufend zu sein, der sich in der ersten Richtung erstreckt, wie in der zweiten Richtung von einem Ende des Teilabschnitts (I) zu dem anderen Ende des Teilabschnitts (I) in der ersten Richtung zu sehen ist,
ein Abstand zwischen leitfähigen Baugliedern (20, 20a-20m), die zueinander in der zweiten Richtung benachbart sind, in dem zweiten Zustand kürzer ist als ein Abstand zwischen leitfähigen Baugliedern (20, 20a-20m), die in der zweiten Richtung zueinander benachbart sind, in dem ersten Zustand, wodurch ein leitfähiger Weg gebildet wird.

2. Der elastische Leiter gemäß Anspruch 1, bei dem jedes der Mehrzahl von leitfähigen Baugliedern (20, 20a-20m) aus einem Metallmaterial in einem Volumenzustand oder aus einer Metallfolie gebildet ist.

3. Der elastische Leiter gemäß Anspruch 1 oder 2, der ferner ein Einschränkungsbauglied (30, 30E, 30a, 30d) aufweist, das einen höheren Elastizitätsmodul als das dehnbare Basisbauglied (10, 10F) aufweist, wobei das Einschränkungsbauglied (30, 30E, 30a, 30d) dazu konfiguriert ist, eine Ausdehnung und Zusammenziehung des dehnbaren Basisbauglieds (10, 10F) in der zweiten Richtung zu unterdrücken, wobei
in dem zumindest einen Teilabschnitt (I) zwei oder mehr leitfähige Bauglieder (20, 20a-20m) der Mehrzahl von leitfähigen Baugliedern (20, 20a-20m) in der zweiten Richtung nebeneinander angeordnet sind, um eine Region mit hoher Dichte und eine Region mit geringer Dichte zu bilden, wobei
in der Region mit hoher Dichte die leitfähigen Bauglieder (20, 20a-20m) entlang einer Breite des dehnbaren Basisbauglieds (10, 10F) in der zweiten Richtung zahlenmäßig dichter als in der Region mit geringer Dichte vertreten sind; und
in der Region mit geringer Dichte die leitfähigen Bauglieder (20, 20a-20m) entlang der Breite des dehnbaren Basisbauglieds (10, 10F) in der zweiten Richtung zahlenmäßig weniger dicht als in der Region mit hoher Dichte vertreten sind, und
das Einschränkungsbauglied (30, 30E, 30a, 30d) auf einer hinteren Oberfläche des dehnbaren Basisbauglieds (10, 10F) bereitgestellt ist, um mit der Region mit geringer Dichte zu überlappen, wie in einer normalen Richtung der Oberfläche des dehnbaren Basisbauglieds (10, 10F) zu sehen ist.

4. Der elastische Leiter gemäß Anspruch 1 oder 2, der ferner ein Einschränkungsbauglied (30, 30E, 30a, 30d) aufweist, das einen höheren Elastizitätsmodul als das dehnbare Basisbauglied (10, 10F) aufweist, wobei das Einschränkungsbauglied (30, 30E, 30a, 30d) dazu konfiguriert ist, eine Ausdehnung und Zusammenziehung des dehnbaren Basisbauglieds (10, 10F) in der zweiten Richtung zu unterdrücken, wobei
eine Region mit befestigter elektronischer Komponente (R3), auf der eine elektronische Komponente (50) befestigt ist, auf der Oberfläche des dehnbaren Basisbauglieds (10, 10F) bereitgestellt ist, wobei die Oberfläche zu dem zumindest einen Teilabschnitt (I) benachbart ist, und
das Einschränkungsbauglied (30, 30E, 30a, 30d) auf einer hinteren Oberfläche des dehnbaren Basisbauglieds (10, 10F) oder innerhalb des dehnbaren Basisbauglieds (10, 10F) bereitgestellt ist, um mit der Region mit befestigter elektronischer Komponente (R3) zu überlappen, wie in einer normalen Richtung der Oberfläche des dehnbaren Basisbauglieds (10, 10F) zu sehen ist.

5. Der elastische Leiter gemäß Anspruch 1 oder 2, der ferner ein elastisches Basisbauglied (40) aufweist, das eine erste Hauptoberfläche (40a) und eine zweite Hauptoberfläche (40b) aufweist, die in entgegengesetzte Richtungen zeigen, wobei das elastische Basisbauglied (40) dazu konfiguriert ist, das dehnbare Basisbauglied (10, 10F) und die Mehrzahl von leitfähigen Bauglieder (20, 20a-20m) zu tragen, wobei
die Mehrzahl von leitfähigen Baugliedern (20, 20a-20m) auf der ersten Hauptoberfläche (40a) bereitgestellt ist und
das dehnbare Basisbauglied (10, 10F) auf der ersten Hauptoberfläche (40a) bereitgestellt ist, um die Mehrzahl von leitfähigen Baugliedern (20, 20a-20m) zu bedecken.

6. Der elastische Leiter gemäß Anspruch 5, der ferner ein Einschränkungsbauglied (30, 30E, 30a, 30d) aufweist, das einen höheren Elastizitätsmodul als das elastische Basisbauglied (40) aufweist, wobei das Einschränkungsbauglied (30, 30E, 30a, 30d) dazu konfiguriert ist, eine Ausdehnung und Zusammenziehung des elastischen Basisbauglieds (40) in der zweiten Richtung einzuschränken, wobei
in dem zumindest einen Teilabschnitt (I) zwei oder mehr leitfähige Bauglieder (20, 20a-20m) der Mehrzahl von leitfähigen Baugliedern (20, 20a-20m) in der zweiten Richtung nebeneinander angeordnet sind, um eine Region mit hoher Dichte und eine Region mit geringer Dichte zu bilden, wobei:
in der Region mit hoher Dichte die leitfähigen Bauglieder (20, 20a-20m) entlang einer Breite des dehnbaren Basisbauglieds (10, 10F) in der zweiten Richtung zahlenmäßig dichter als in der Region mit geringer Dichte vertreten sind; und
in der Region mit geringer Dichte die leitfähigen Bauglieder (20, 20a-20m) entlang der Breite des dehnbaren Basisbauglieds (10, 10F) in der zweiten Richtung zahlenmäßig weniger dicht als in der Region mit hoher Dichte vertreten sind, und
das Einschränkungsbauglied (30, 30E, 30a, 30d) auf der zweiten Hauptoberfläche (40b) bereitgestellt ist, um mit der Region mit geringer Dichte zu überlappen, bei wie in einer normalen Richtung der zweiten Hauptoberfläche (40b) zu sehen ist.

7. Der elastische Leiter gemäß Anspruch 5, der ferner ein Einschränkungsbauglied (30, 30E, 30a, 30d) aufweist, das einen höheren Elastizitätsmodul als das elastische Basisbauglied (40) aufweist, wobei das Einschränkungsbauglied (30, 30E, 30a, 30d) dazu konfiguriert ist, eine Ausdehnung des elastischen Basisbauglieds (40) in der zweiten Richtung zu unterdrücken, wobei
eine Region mit befestigter elektronischer Komponente (R3), auf der eine elektronische Komponente (50) befestigt ist, auf der Oberfläche des dehnbaren Basisbauglieds (10, 10F) bereitgestellt ist, wobei die Oberfläche zu dem zumindest einen Teilabschnitt (I) benachbart ist, und
das Einschränkungsbauglied (30, 30E, 30a, 30d) dahin gehend bereitgestellt ist, mit der Region mit befestigter elektronischer Komponente (R3) zu überlappen, wie in einer normalen Richtung der zweiten Hauptoberfläche (40b) zu sehen ist.

## Revendications

1. Conducteur élastique configuré pour être modifiable entre un premier état avant qu'une force de tension n'agisse dans une première direction et un second état dans lequel la force de tension agit dans la première direction pour amener le conducteur élastique à être expansé dans la première direction, le conducteur élastique comprenant :
un élément de base extensible (10, 10F) présentant une conductivité ; et
une pluralité d'éléments conducteurs (20, 20a-20m), chacun agencé sur une surface de l'élément de base extensible (10, 10F) ou à l'intérieur de l'élément de base extensible (10, 10F), chacun de la pluralité d'éléments conducteurs (20, 20a-20m) étant inférieur du point de vue de la résistance spécifique et supérieur du point de vue du module d'élasticité à l'élément de base extensible (10, 10F),
**caractérisé en ce que**, dans le premier état, chacun de la pluralité d'éléments conducteurs (20, 20a-20m) a une forme longitudinale s'étendant dans la première direction,
dans le premier état, la pluralité d'éléments conducteurs (20, 20a-20m) étant agencés pour être espacés les uns des autres dans une seconde direction perpendiculaire à la première direction, et être continus dans au moins une section partielle (I) s'étendant dans la première direction, comme observé dans la seconde direction à partir d'une extrémité de la section partielle (I) jusqu'à l'autre extrémité de la section partielle (I) dans la première direction,
une distance entre les éléments conducteurs (20, 20a-20m) adjacents entre eux dans la seconde direction dans le second état, étant plus courte qu'une distance entre les éléments conducteurs (20, 20a-20m) adjacents entre eux dans la seconde direction dans le premier état, formant ainsi une trajectoire de conduction.

2. Conducteur élastique selon la revendication 1, dans lequel chacun de la pluralité d'éléments conducteurs (20, 20a-20m) est formé avec un matériau métallique dans un état en vrac ou une feuille métallique.

3. Conducteur élastique selon la revendication 1 ou 2, comprenant en outre un élément de retenue (30, 30E, 30a, 30d) qui est supérieur du point de vue du module d'élasticité à l'élément de base extensible (10, 10F), l'élément de retenue (30, 30E, 30a, 30d) étant configuré pour supprimer l'expansion et la contraction de l'élément de base extensible (10, 10F) dans la seconde direction, dans lequel :
dans la au moins une section partielle (I), deux éléments conducteurs (20, 20a-20m) ou plus de la pluralité d'éléments conducteurs (20, 20a-20m) sont agencés côte à côte dans la seconde direction, afin de former une région dense et une région clairsemée, dans lequel :
dans la région dense, les éléments conducteurs (20, 20a-20m) le long d'une largeur de l'élément de base extensible (10, 10F) dans la seconde direction sont plus denses du point de vue du nombre que la région clairsemée ; et
dans la région clairsemée, les éléments conducteurs (20, 20a-20m) le long de la largeur de l'élément de base extensible (10, 10F) dans la seconde direction, sont plus clairsemés du point de vue du nombre que dans la région dense, et
l'élément de retenue (30, 30E, 30a, 30d) est prévu sur une surface arrière de l'élément de base extensible (10, 10F) afin de recouvrir la région clairsemée, comme observé dans une direction normale de la surface de l'élément de base extensible (10, 10F).

4. Conducteur élastique selon la revendication 1 ou 2, comprenant en outre un élément de retenue (30, 30E, 30a, 30d) qui est supérieur du point de vue du module d'élasticité, à l'élément de base extensible (10, 10F), l'élément de retenue (30, 30E, 30a, 30d) étant configuré pour supprimer l'expansion et la contraction de l'élément de base extensible (10, 10F) dans la seconde direction, dans lequel :
une région de montage de composant électronique (R3) ayant un composant électronique (50) monté sur cette dernière, est prévue sur la surface de l'élément de base extensible (10, 10F), la surface étant adjacente à la au moins une section partielle (I), et
l'élément de retenue (30, 30E, 30a, 30d) est prévu sur une surface arrière de l'élément de base extensible (10, 10F) ou à l'intérieur de l'élément de base extensible (10, 10F) afin de recouvrir la région de montage de composant électronique (R3), comme observé dans une direction normale de la surface de l'élément de base extensible (10, 10F).

5. Conducteur élastique selon la revendication 1 ou 2, comprenant en outre un élément de base élastique (40) ayant une première surface principale (40a) et une seconde surface principale (40b) qui se font face dans des directions opposées, l'élément de base élastique (40) étant configuré pour supporter l'élément de base extensible (10, 10F) et la pluralité d'éléments conducteurs (20, 20a-20m), dans lequel :
la pluralité d'éléments conducteurs (20, 20a-20m) sont prévus sur la première surface principale (40a), et
l'élément de base extensible (10, 10F) est prévu sur la première surface principale (40a) pour recouvrir la pluralité d'éléments conducteurs (20, 20a-20m).

6. Conducteur élastique selon la revendication 5, comprenant en outre un élément de retenue (30, 30E, 30a, 30d) qui est supérieur du point de vue du module d'élasticité à l'élément de base élastique (40), l'élément de retenue (30, 30E, 30a, 30d) étant configuré pour retenir l'expansion et la contraction de l'élément de base élastique (40) dans la seconde direction, dans lequel :
dans la au moins une section partielle (I), deux éléments conducteurs (20, 20a-20m) ou plus de la pluralité d'éléments conducteurs (20, 20a-20m) sont agencés côte à côte dans la seconde direction, afin de former une région dense et une région clairsemée, dans lequel :
dans la région dense, les éléments conducteurs (20, 20a-20m) le long d'une largeur de l'élément de base extensible (10, 10F) dans la seconde direction sont plus denses du point de vue du nombre que dans la région clairsemée ; et
dans la région clairsemée, les éléments conducteurs (20, 20a-20m) le long de la largeur de l'élément de base extensible (10, 10F) dans la seconde direction sont plus clairsemés du point de vue du nombre que dans la région dense, et
l'élément de retenue (30, 30E, 30a, 30d) est prévu sur la seconde surface principale (40b) afin de recouvrir la région clairsemée, comme observé dans une direction normale de la seconde surface principale (40b).

7. Conducteur élastique selon la revendication 5, comprenant en outre un élément de retenue (30, 30E, 30a, 30d) qui est supérieur du point de vue du module d'élasticité, à l'élément de base élastique (40), l'élément de retenue (30, 30E, 30a, 30d) étant configuré pour supprimer l'expansion de l'élément de base élastique (40) dans la seconde direction, dans lequel :
une région de montage de composant électronique (R3) ayant un composant électronique (50) monté sur cette dernière, est prévue sur la surface de l'élément de base extensible (10, 10F), la surface étant adjacente à la au moins une section partielle (I), et
l'élément de retenue (30, 30E, 30a, 30d) est prévu pour recouvrir la région de montage de composant électronique (R3), comme observé dans une direction normale de la seconde surface principale (40b).
